Europäisches Patentamt

European Patent Office

Office européen des brevets

(11) Publication number: 0 629 040 A1

## EUROPEAN PATENT APPLICATION

(21) Application number: 93401480.4

(22) Date of filing: 10.06.93

(51) Int. Cl.5: H03D 1/22, H03D 3/00

(43) Date of publication of application:
14.12.94 Bulletin 94/50

(84) Designated Contracting States:
DE ES FR GB IT

(71) Applicant: THOMSON CONSUMER
ELECTRONICS S.A.
9, Place des Vosges,
La Défense 5
F-92400 Courbevoie (FR)

(72) Inventor: Boie, Werner
15, rue du Ziegelfeld
F-67100 Strasbourg (FR)

(74) Representative: Wördemann, Hermes
Deutsche Thomson-Brandt GmbH,
Patents and Licensing,
Göttinger Chaussee 76
D-30453 Hannover (DE)

(54) Method and apparatus for IF demodulation of a high frequency input signal.

(57) Usual A/D converters are not suited for digitising video IF signals because video signals have a much higher bandwidth and because video signals are vestigal-sideband modulated.

The inventive analogue-to-digital conversion circumvents the low dynamic resolution problem of the ADC and allows the application of low-cost ADCs. The problem of low dynamic range with IF digitising can be overcome by combining the basic super-heterodyne principle and the digitising of an in-phase and a quadrature component of a zero-IF and by using a reduced sampling clock for the ADCs.

Fig. 2

Rank Xerox (UK) Business Services
(3.10/3.09/3.3.4)

The present invention relates to a method and to an apparatus for IF demodulation of a high frequency input signal.

## Background

The use of digital signal processing in modern TV receiver design should allow to perform many of signal conditioning, filtering and demodulation functions in a more flexible and economical way as it is the case today with analogue components, thus, conferring an improved performance.

The digital processing starts with an A/D conversion, if possible, it should include the IF processing. The digitising of audio IF signals is known from "Undersampling Techniques Simplifying Digital Radio", Electronics Design 67, May 23, 1991.

But such techniques are not suitable for video IF signals for two reasons:

- video signals have a much higher bandwidth,
- video signals are vestigal-sideband modulated (VSB).

## Invention

It is one object of the invention to disclose a method of digitising video IF signals using existing A/D converters. This object is reached by the method disclosed in claim 1.

It is a further object of the invention to disclose an apparatus which utilises the inventive method. This object is reached by the apparatus disclosed in claim 9.

At present, the ADC technology can be considered as a principal constraint to the advancement of digitally implemented concepts in the IF part of an TV receiver. Although this area of technology is undergoing a rapid development it cannot be expected that in the next years low-cost ADCs will come on the market which can meet the requirements for such digital TV processing. The inventive analogue-to-digital conversion architecture circumvents the ADC problems and allows the application of low-cost ADCs. The invention allows digitising of VSB modulated IF signals of high bandwidth, e.g. TV signals.

The potential achievements of a subsequent digital processing may be summarised as:

- a reduction in the complexity of analogue elements of the design;
- the ability to re-configure a TV receiver or VCR, without any increase in hardware, to a variety of different TV standards;
- the ability to provide a range of tailored filter functions (f.i. sound trap);
- the ability to apply on-line correction algorithms (AGC, AFC, etc.);

- the application of novel demodulation techniques.

The choice of a suitable digital-signal-processing-based TV receiver architecture is partly determined by the performance of the currently available low-cost analogue-to-digital converters (ADC). The dynamic range and the sampling rate of the available ADCs play an important role in this respect. Regarding an IF frequency of about 40 MHz to be digitised with a minimum dynamic resolution of 10 bits does already lead to requirements which cannot be fulfilled even by today's highly sophisticated ADCs. According to the invention, the problem of low dynamic range with IF digitising can be overcome by combining the basic super-heterodyne principle and the digitising of an in-phase and a quadrature component of a zero-IF and by using a reduced sampling clock for the ADCs.

In principle the inventive method is suited for IF demodulation of a high frequency input signal, wherein a first mixing stage and first local oscillator means and first filter means are used to generate a first IF signal and wherein that said first IF signal is formed in two parallel branches to an in-phase component of a second IF signal and to a quadrature component of said second IF signal using second local oscillator means and wherein said in-phase component and said quadrature component are each A/D converted and are re-modulated and combined in the digital domain using a third local oscillator means and combining means, thereby forming a digital IF signal.

Advantageous additional embodiments of the inventive method are resulting from the respective dependent claims.

In principle the inventive apparatus for IF demodulation of a high frequency input signal comprises:

- a first mixing stage and first local oscillator means and first filter means which are used to generate a first IF signal;
- subsequently, two parallel branches which each comprises a further mixing stage and further filter means and which form from said first IF signal an in-phase component of a second IF signal and a quadrature component of said second IF signal using second local oscillator means and first 90° phase shifting means;
- A/D converting means which convert said in-phase component and said quadrature component to the digital domain;
- subsequently, further mixing stages which re-modulate each of said components in the digital domain using third local oscillator means and second 90° phase shifting means;

- combining means which form from said re-modulated components a digital IF signal.

Advantageous additional embodiments of the inventive apparatus are resulting from the respective dependent claim.

Drawings

Preferred embodiments of the invention are described with reference to the accompanying drawings, which show in:

Fig. 1    dynamic resolution of a flash A/D converter;

Fig. 2    principle of inventive tuner with digital IF;

Fig. 3    inventive conversion from the analogue IF to a digital IF signal;

Fig. 4    continuation of Fig. 3;

Fig. 5    aliasing in the digitised IF signal.

Preferred embodiments

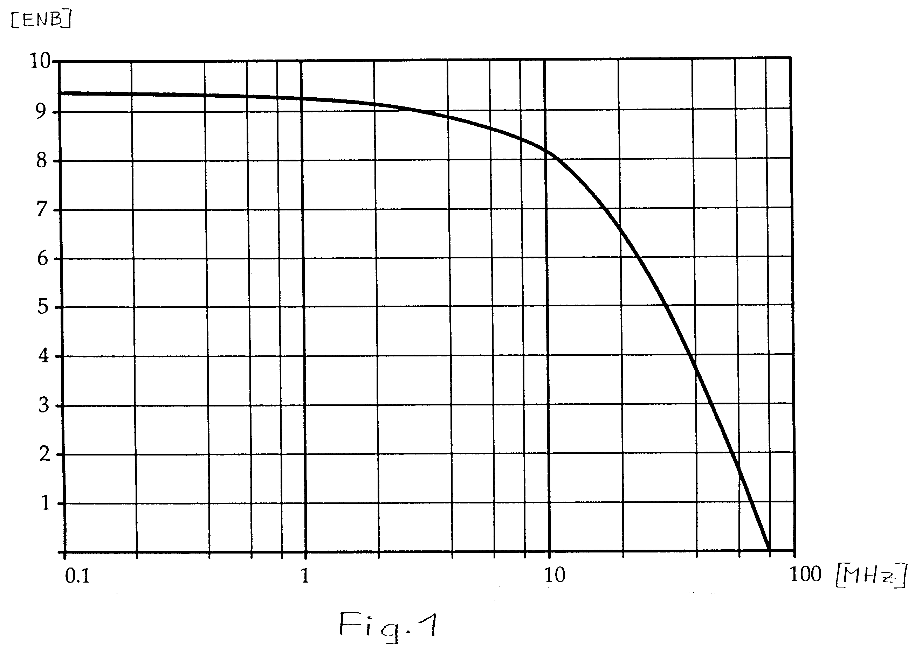

Fig. 1 shows the typical dynamic resolution (effective number of bits ENB) of a 10 bit ADC versus the input frequency.

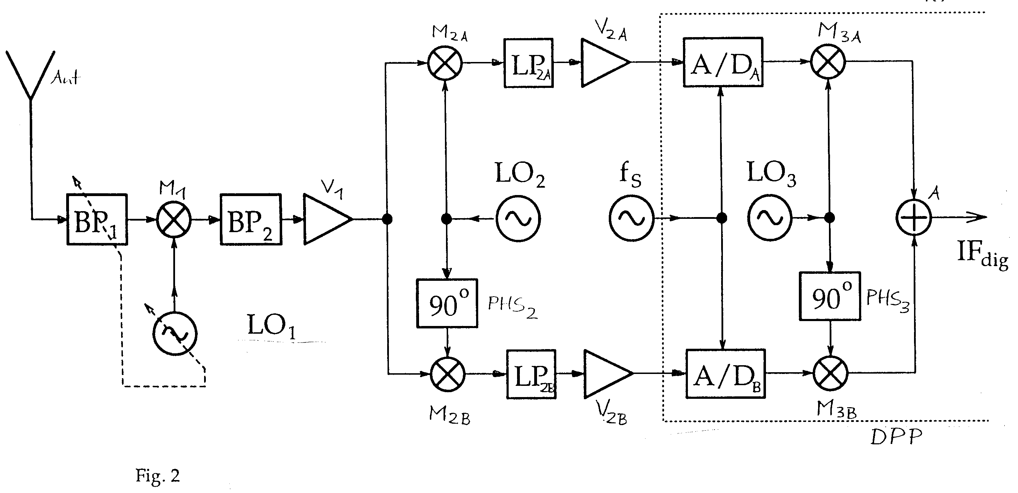

The depicted tuner concept in Fig. 2 is based on a double conversion tuner having a high first IF frequency region. A tuner input receives from an antenna Ant e.g. input frequencies in the range 40 ... 900MHz. A first controllable bandpass $BP_1$ selects e.g. a TV channel. Its output signal is mixed in a mixing stage $M_1$ with the output frequency of a first local oscillator $LO_1$ which serves in connection with $BP_1$ to select a channel. The resulting output signal passes a second bandpass $BP_2$ forming a first IF signal and is amplified in a first IF amplifier stage $V_1$. Advantageously, the first IF signal lies in the range 1 ... 2GHz.

The first IF signal then passes through two parallel chains.

Chain A comprises:
- a second mixing stage $M_{2A}$ which receives as second input the signal of a second local oscillator $LO_2$ the frequency of which leads to a zero-IF;
- a first low pass $LP_{2A}$ which delivers the in-phase IF component;
- a second IF amplifier $V_{2A}$ which can be AGC controlled;
- a first A/D converter $A/D_A$ which is clocked with the sampling frequency $f_s$;
- a third mixer stage $M_{3A}$ which receives as second input the signal of a third local oscillator $LO_3$ and which delivers a first component of the final digital IF signal $IF_{dig}$.

Chain B comprises:
- a fourth mixing stage $M_{2B}$ which receives as second input the signal of the second local oscillator $LO_2$ after having passed through a first 90° phase shifter $PHS_2$;
- a second low pass $LP_{2B}$ which delivers the quadrature IF component;
- a third IF amplifier $V_{2B}$ which can be AGC controlled;
- a second A/D converter $A/D_B$ which is clocked with the same sampling frequency $f_s$;
- a fifth mixer stage $M_{3B}$ which receives as second input the signal of the third local oscillator $LO_3$ after having passed through a second 90° phase shifter $PHS_3$. $M_{3B}$ delivers a second component of the final digital IF signal $IF_{dig}$.

This tuner concept offers two considerable advantages:
- Firstly, the image response filtering becomes trivial, that means the lowest image frequency is located beyond 2GHz;
- Secondly, the synthesiser $LO_1$ needs only to tune less than one octave.

The second IF frequency at the output of $LP_{2A}$ and $LP_{2B}$ corresponds to a complex zero-IF frequency. For the conversion, both, the in-phase and the quadrature IF component are lowpass filtered prior to the digitising by the A/D converters which can be of low-cost type. The minimum sampling frequency of the ADCs applicable is, of course, determined by the sampling theorem but an over-sampling frequency of 30 ... 40MHz would offer the application of simple analogue pre-filters. Afterwards in the digital domain, both components are re-modulated by means of the complex local oscillator frequency $LO_3$. Then the sum of both re-modulated components is formed in an adding stage A, resulting in the digitised IF signal $IF_{dig}$ which will be subjected to an actual subsequent signal processing like Nyquist-filtering, VSB-AM demodulation of the video signal.

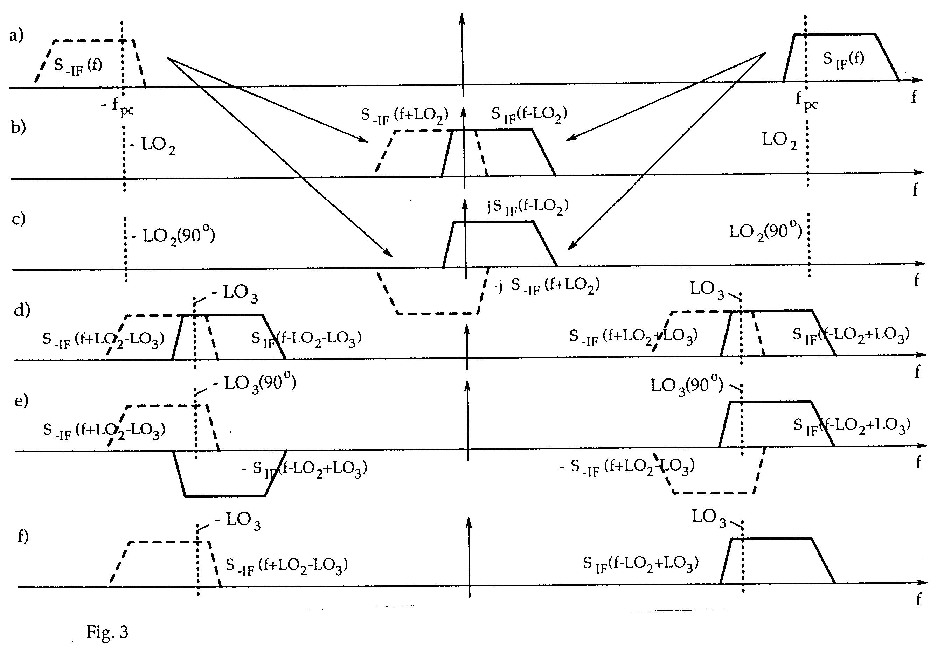

An explanation of the analogue-to-digital conversion of the IF signal in the frequency domain is depicted in Fig. 3. Given the spectrum of the first IF signal (output of $V_1$) by (Fig. 3a):

$$IF_{analogue}(f) = S_{if}(f) + S_{-if}(f),$$

with $S_{if}(f)$ for $f≥0$, and $S_{-if}(f)$ for $f<0$. $f_{PC}$ is the picture carrier.

The output signals of the in-phase and quadrature mixer stage (output $M_{2A}/M_{2B}$) are:

$$M_{in-phase}(f) = [S_{if}(f) + S_{-if}(f)] * [\delta(f-LO_2) + \delta(f+LO_2)] = S_{if}(f-LO_2) + S_{if}(f+LO_2) + S_{-if}(f-LO_2) + S_{-if}(f+LO_2)$$

and

$$M_{quadrature}(f) = [S_{if}(f) + S_{-if}(f)] * [\delta(f-LO_2) - \delta$$

$(f + LO_2)]/j = [S_{if}(f-LO_2) - S_{if}(f + LO_2) + S_{-if}(f-LO_2) - S_{-if}(f + LO_2)]/j$

After lowpass filtering (output $LP_{2A}/LP_{2B}$) all RF signal components disappear. Therefore, the input signals of the ADCs are:

$\{M_{in-phase}(f)\}_{LP} = S_{if}(f-LO_2) + S_{-if}(f + LO_2)$     (Fig. 3b)

and

$\{M_{quadrature}(f)\}_{LP} = [S_{if}(f-LO_2) - S_{-if}(f + LO_2)]/j$     - (Fig. 3c)

Because assuming that no aliasing will occur in the digitising process, the mathematical description of the sampling process is ignored for the sake of simplicity.

The complex re-modulation by means of the local oscillator frequency $LO_3$ in the digital domain yields then:

$M2_{in-phase}(f) = \{M_{in-phase}(f)\}_{LP} * [\delta(f-LO_3) + \delta-(f + LO_3)]/2 = [S_{if}(f-LO_2-LO_3) + S_{if}(f-LO_2 + LO_3) + S_{-if}(f + LO_2-LO_3) + S_{-if}(f + LO_2 + LO_3)]/2$     - (Fig. 3d)

and

$M2_{quadrature}(f) = \{M_{quadrature}(f)\}_{LP} * [\delta(f-LO_3) - \delta-(f + LO_3)]/j2 = -[S_{if}(f-LO_2-LO_3) - S_{if}(f-LO_2 + LO_3) + S_{-if}(f + LO_2-LO_3) - S_{-if}(f + LO_2 + LO_3)]/2$     (Fig. 3e)

After superposing the resulting in-phase and quadrature component the original but frequency shifted IF signal is reconstructed according to Fig. 3f:

$IF_{dig}(f) = M2_{in-phase}(f) + M2_{quadrature}(f) = S_{if}(f-[LO_2-LO_3]) + S_{-if}(f + [LO_2-LO_3])$

Advantageously, the location on the f axis does not matter in the digital domain.

The above considered concept offers a large scope in choosing the sampling frequency $f_s$ and the digital local oscillator frequency $LO_3$. This is a quite welcome feature if one regards the succeeding filter applications like Nyquist-filtering of a VSB-AM modulated video signal.

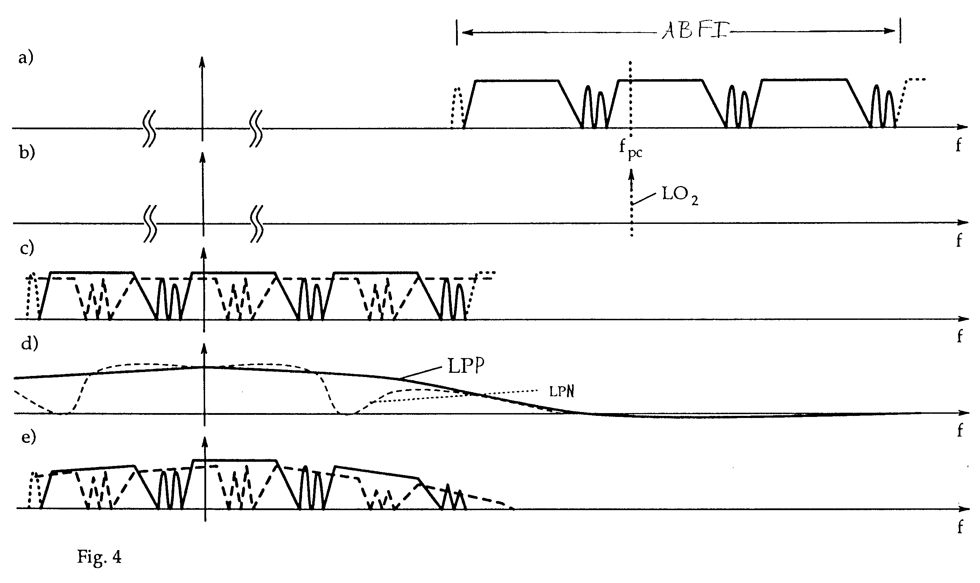

Fig. 3 has only given a simplified illustration of the conversion process which needs now to be considered with a closer look at the actual spectra in the analogue IF domain. In order to regard more or less the worst case condition, beside the wanted signal spectrum also the adjacent channel signals have to be included into the consideration as shown in Fig. 4a. ABFI is the assumed bandwidth of the first IF signal. By means of local oscillator frequency $LO_2$ depicted in Fig. 4b the analogue IF signal is down-converted to zero-frequency according to Fig. 4c, if in Fig. 4a the picture carrier fpc is taken as a reference which is not a necessary condition. Due to the non-symmetric spectra of the VSB-signals an overlapping of originally different frequency components takes place in the baseband region. The mixing causes also down-converted negative frequency components, which are not depicted in Fig. 4. As a result of this down-conversion, beyond 1MHz different frequency components will overlap as illustrated in Fig. 4c. The dashed line shows a quadrature component like frequency component. These erroneous frequency components can only be removed or compensated by adding the quadrature component later on as described above with reference to Fig. 3.

The whole conversion process has to be carried out with high linearity in order to enable a compensation of the erroneous frequency components in the digital domain. As stated above, the dynamic resolution of the ADCs will play a major role in this respect, but also the amplitude linearity of the in-phase and quadrature mixer stages $M_{2A}$ and $M_{2B}$.

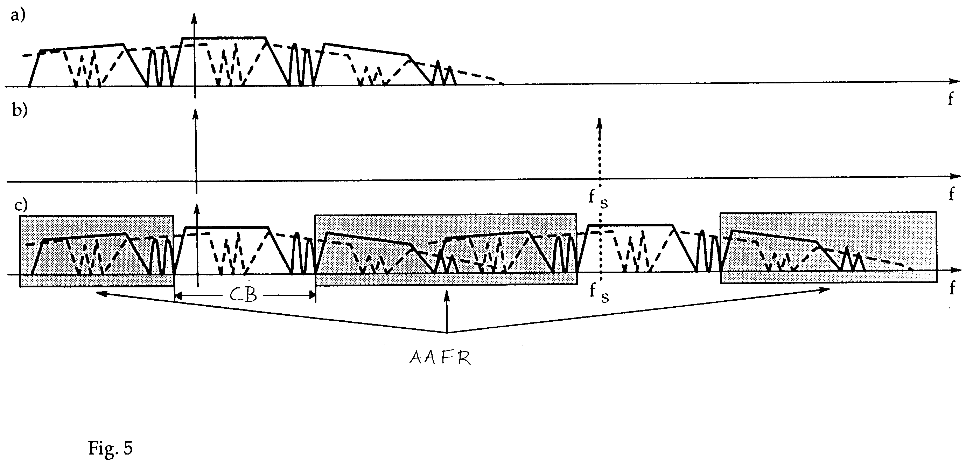

As prefilter $LP_{2A}$ and $LP_{2B}$ for the ADCs, simple low-cost lowpass filters LPP (see Fig. 4d) can be applied to suppress the RF signal components. The resulting ADC input signals of Fig. 4e and Fig. 5a consist not only of the wanted signal but also of a superposition of adjacent channel signals. Therefore, the wanted signal will encounter in the temporal domain a dynamic range of the ADC reduced by a factor of at least 2, more likely of 4.

Taking an 8 bit resolution of the CVBS signal after demodulation as a minimum requirement, the digitising of the analogue IF signals requires a resolution of at least 10 bits. Normally, a large amount of energy is located around the vision carrier. Thus, it seems reasonable to use a prefilter LPN having notches at the adjacent channel vision carrier frequencies, but this requirement would also complicate the prefilter and consequently increase the costs. A trade-off between the available dynamic resolution of the ADC on one hand and the complexity of the prefilter on the other hand becomes discernible.

Another interesting role in this context plays the choice of the sampling frequency $f_s$. According to Fig. 5b, a sampling frequency $f_s$ being 3 or 4 times greater than the channel bandwidth CB is quite advantageous. In this case, the resulting aliasing in the adjacent channels does not disturb the wanted signal as shown in Fig. 5c.

If in case of Nyquist-filtering the Nyquist point is set to $f_s/4$, an advantageous low number of coefficients is required for the Nyquist filter.

Taking not into account the non-linear behaviour of the ADC's quantisation characteristic, a higher sampling frequency (over-sampling) also allows a higher dynamic resolution in connection with digital post-filtering.

Because large signal amplitudes in the adjacent channels coming from a TV transmitter nearby may be mixed into the zero-IF by phase noise components of the local oscillator, the quality of the local oscillator $LO_2$ will affect the overall performance of the digitising process.

An AGC control of the zero-frequency IF signals at the input of the ADCs is advantageous in order to utilise the full dynamic range of the ADCs $A/D_A$ and $A/D_B$.

Similarly, a 10 or more bit analogue-to-digital conversion of a modulated audio signal which occupies only a small part of the amplitude range of the IF signal will not lead to satisfactory results. Therefore, a parallel architecture for the sound demodulation can be used.

## Claims

1. Method for IF demodulation of a high frequency input signal, wherein a first mixing stage ($M_1$) and first local oscillator means ($LO_1$) and first filter means ($BP_1$, $BP_2$) are used to generate a first IF signal, **characterised in** that said first IF signal is formed in two parallel branches ($M_{2A}$, $LP_{2A}$; $M_{2B}$, $LP_{2B}$) to an in-phase component ($M_{in-phase}$) of a second IF signal and to a quadrature component ($M_{quadrature}$) of said second IF signal using second local oscillator means ($LO_2$), wherein said in-phase component and said quadrature component are each A/D converted ($A/D_A$, $A/D_B$) and are re-modulated and combined in the digital domain using a third local oscillator means ($LO_3$) and combining means (A), thereby forming a digital IF signal ($IF_{dig}$).

2. Method according to claim 1, **characterised in** that said high frequency input signal is a vestigal-sideband modulated signal, especially an UHF TV signal.

3. Method according to claim 1 or 2, **characterised in** that said second local oscillator means ($LO_2$) have a frequency which leads principally to a zero-IF for said second IF signal.

4. Method according to any of claims 1 to 3, **characterised in** that the sampling frequency ($f_s$) used in said A/D conversion ($A/D_A$, $A/D_B$) is a multiple - especially three or four - of the channel bandwidth (CB) of said high frequency input signal.

5. Method according to any of claims 1 to 4, **characterised in** that each of said parallel branches comprises a further mixing stage ($M_{2A}$, $M_{2B}$) and further filter means ($LP_{2A}$, $LP_{2B}$).

6. Method according to any of claims 1 to 5, **characterised in** that each of said parallel branches comprises AGC controlled amplifier means ($V_{2A}$, $V_{2B}$) causing a subsequent full range A/D conversion.

7. Method according to any of claims 1 to 6, **characterised in** that said quadrature component is formed ($M_{2B}$) using first 90° phase shifting means ($PHS_2$) and that the re-modulation of said quadrature component is performed ($M_{3B}$) using second 90° phase shifting means ($PHS_3$)

8. Method according to any of claims 4 to 7, **characterised in** that a Nyquist-filtering is performed on said digital IF signal ($IF_{dig}$), wherein the Nyquist point is set to one quarter of said sampling frequency ($f_s$).

9. Apparatus for IF demodulation of a high frequency input signal, related to a method according to any of claims 1 to 8 and comprising:
   - a first mixing stage ($M_1$) and first local oscillator means ($LO_1$) and first filter means ($BP_1$, $BP_2$) which are used to generate a first IF signal;
   - subsequently, two parallel branches which each comprises a further mixing stage ($M_{2A}$, $M_{2B}$) and further filter means ($LP_{2A}$, $LP_{2B}$) and which form from said first IF signal an in-phase component ($M_{in-phase}$) of a second IF signal and a quadrature component ($M_{quadrature}$) of said second IF signal using second local oscillator means ($LO_2$) and first 90° phase shifting means ($PHS_2$);
   - A/D converting means ($A/D_A$, $A/D_B$) which convert said in-phase component and said quadrature component to the digital domain;
   - subsequently, further mixing stages ($M_{3A}$, $M_{3B}$) which re-modulate each of said components in the digital domain using third local oscillator means ($LO_3$) and second 90° phase shifting means ($PHS_3$);

- combining means (A) which form from said re-modulated components a digital IF signal ($IF_{dig}$).

10. Apparatus according to claim 9, **characterised in** that said second local oscillator means ($LO_2$) have a frequency which leads principally to a zero-IF for said second IF signal

Fig.1

[ENB]

[MHz]

EP 0 629 040 A1

Fig. 2

EP 0 629 040 A1

Fig. 3

Fig. 4

a)

b)

c)

$f_s$

$f_s$

CB

AAFR

Fig. 5

EP 0 629 040 A1

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | US-A-5 003 621 (GAILUS)<br><br>* column 4, line 47 - line 64 *<br>--- | 1,3,5,9,10 | H03D1/22<br>H03D3/00 |
| X | EP-A-0 255 553 (DEUTSCHE ITT INDUSTRIES GMBH)<br>* abstract; figure 1 *<br>--- | 1,9 | |
| A | EP-A-0 151 281 (LICENTIA PATENT-VERWALTUNGS-GMBH)<br>* page 4, line 30 - page 5, line 4; figure 2 *<br>----- | 1,6 | |
| | | | TECHNICAL FIELDS SEARCHED (Int.Cl.5)<br><br>H03D<br>H03J |

The present search report has been drawn up for all claims

| Place of search | Date of completion of the search | Examiner |
|---|---|---|
| THE HAGUE | 5 November 1993 | PEETERS, M |

EPO FORM 1503 03.82 (P04C01)